# DEMANDE DE BREVET EUROPEEN

(11) **EP 3 748 831 A1**
(43) Date de publication de la demande: **09.12.2020**
(21) Numéro de dépôt: 20173077.7
(22) Date de dépôt: 05.05.2020
(51) Int. Cl.: H02M 1/42, H02M 1/36, H03K 17/78, H02M 3/158

(54) **UN CONVERTISSEUR ET SON SYSTEME DE CONTROLE DE COURANT**

(30) Priorité: 07.06.2019 FR 1906070
(71) Demandeur: Valeo Siemens eAutomotive France SAS, 95800 Cergy (FR)
(72) Inventeur: MESSI BENE ELOUNDOU, Norbert, 90000 BELFORT (FR); MANI, Singaravelu, 600056 CHENNAI (IN)
(74) Mandataire: Argyma

(57) **Abrégé**

L'invention concerne un convertisseur (10) configuré pour alimenter un élément consommateur d'énergie (M1) lors d'une phase de fonctionnement, ainsi que pour charger ladite capacité (C1) lors d'une phase de précharge préalable à la phase de fonctionnement. Ledit convertisseur (10) comprend un circuit PFC (désigné « circuit de correction de facteur de puissance ») comportant ladite capacité (C1) et des thyristors (TR1, TR2). Ledit convertisseur (10) comprend en outre un système de contrôle (100) configuré pour contrôler ladite phase de précharge. Ledit système de contrôle (100) comprend une unité de contrôle (110) configurée pour, lors de ladite phase de fonctionnement, détecter l'état de charge de la capacité (C1), ainsi que pour générer un signal de commande destiné à commander lesdits thyristors (TR1, TR2) en fonction de l'état de charge de la capacité (C1).

## Description

### DOMAINE TECHNIQUE ET OBJET DE L'INVENTION

La présente invention concerne, de façon générale, un convertisseur, notamment pour un chargeur électrique d'un véhicule électrique.

L'invention porte plus particulièrement sur un convertisseur et son système de contrôle.

### ETAT DE LA TECHNIQUE

De manière connue, un chargeur électrique d'un véhicule électrique (désigné « Electric Vehicle » en anglais, l'abréviation « EV ») ou hybride comprend un convertisseur comprenant un circuit de correction du facteur de puissance (désigné « Power Factor Correction » en anglais, correspondant à l'abréviation « PFC »). Il existe plusieurs topologies de circuits PFC mises en œuvre dans les convertisseurs, notamment pour des chargeurs électriques pour véhicule.

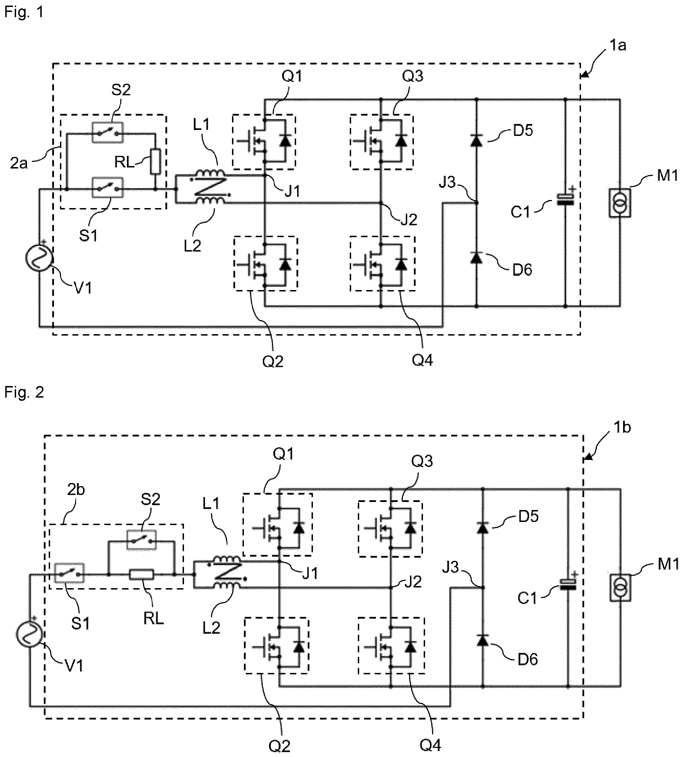

Parmi ces topologies connues, le circuit PFC en totem-pole entrelacé sans pont (désigné « interleaved totem pole bridgeless PFC » en anglais) est considéré comme une topologie PFC attrayante par rapport aux autres topologies PFC connues car il permet à un convertisseur, non seulement de comprendre moins de composants électroniques, mais aussi de présenter de faibles pertes. Ledit circuit PFC en totem-pole entrelacé sans pont est souvent associé à une capacité de bus continue (désigné « DC-link Capacitor » en anglais). Avant de réaliser un transfert d'énergie pour alimenter un élément consommateur d'énergie, la capacité de bus continue nécessite d'être préalablement chargée, afin d'éviter un courant d'appel lors du fonctionnement du convertisseur. Deux circuits de commutation 2a et 2b, connus de leurs applications pour la précharge d'une capacité, sont respectivement décrits en figures 1 et 2.

La figure 1 illustre une topologie de circuit PFC utilisé pour un convertisseur 1a connecté à une source de tension alternative V1 et à un élément consommateur d'énergie M1. Le convertisseur 1a comprend un circuit PFC et un circuit de commutation 2a. Le circuit de commutation 2a est configuré pour contrôler un courant circulant entre la source de tension alternative V1 et le convertisseur 1a, soit lors d'une phase de précharge à laquelle une capacité C1 du convertisseur 1a est chargée, soit lors d'une phase de fonctionnement à laquelle l'élément consommateur d'énergie M1 consomme l'énergie électrique fournie par la source de tension alternative V1.

Ledit circuit PFC est un circuit PFC en totem-pole entrelacé sans pont comprenant une pluralité d'interrupteurs Q1 à Q4, au moins une diode D5 et D6, un transformateur, et la capacité C1. Les interrupteurs Q1 à Q4 sont des transistors MOSFET (désigné « Metal Oxide Semiconductor Field Effect Transistor » en anglais). Les interrupteurs Q1 et Q2 sont connectés en série et forment ainsi un premier bras. Les interrupteurs Q3 et Q4 sont connectés en série et forment un deuxième bras. Le transformateur comprend deux inductances L1 et L2 dont chacune comprend, comme illustré en figure 1, une borne connectée à un nœud J1 ou J2 correspondant à un point milieu dudit premier bras ou dudit deuxième bras.

Les diodes D5 et D6 sont respectivement connectées à la capacité C1, aux interrupteurs Q1 à Q4 et à la source de tension alternative V1. Les diodes D5 et D6, connectées en série, sont configurées pour réaliser les redresseurs qui permettent de transformer le courant alternatif généré par la source de tension alternative V1 en courant unidirectionnel. Les diodes D5 et D6 sont des diodes classiques ou celles en carbure de silicium (SiC). De plus, un nœud J3 correspondant à un point de connexion entre les deux diodes D5 et D6, est connecté à une borne négative de la source de tension alternative V1.

Le circuit en série composé des diodes D5 et D6, ledit premier bras, ledit deuxième bras, la capacité C1 et l'élément consommateur d'énergie M1 sont connectés en parallèle.

Le circuit de commutation 2a, connecté à la source de tension alternative V1 et audit circuit PFC, comprend un relais de transfert S1 et un circuit de précharge. Le circuit de précharge comprend un relais de précharge S2 et une résistance de limitation RL qui sont connectés en série. La résistance de limitation RL peut être remplacée par une thermistance. Ledit circuit de précharge est connecté en parallèle du relais de transfert S1. Le relais de transfert S1 et le relais de précharge S2 sont des relais à courant alternatif. La résistance de limitation RL peut être remplacée par un thermistor.

Lors d'une phase de précharge du convertisseur 1a, le relais de précharge S2 est fermé alors que le relais de transfert S1 est ouvert. Le relais de précharge S2 est destiné à déconnecter la résistance de limitation RL une fois que la précharge de la capacité C1 est terminée. Lors d'une phase de fonctionnement du convertisseur 1a, le relais de transfert S1 est fermé alors que le relais de précharge S2 est ouvert. Le relais de transfert S1 du circuit de commutation 2a est alors configuré pour autoriser ou couper le courant transféré entre la source de courant constant V1 et le convertisseur 1a.

La figure 2 illustre une autre configuration d'un circuit de commutation 2b compris dans un convertisseur 1b. Le circuit de commutation 2b comprend également un relais de transfert S1 et un circuit de précharge. La seule différence entre les deux circuits illustrés en figures 1 et 2 réside sur la configuration du circuit de commutation 2b. Le circuit de précharge du circuit de commutation 2b comprend un relais de précharge S2 et une résistance de limitation RL qui sont connectés en parallèle. Dans le circuit de commutation 2b, le circuit de précharge et le relais de transfert S1 sont connectés en série. En figure 2, lors d'une phase de précharge du convertisseur 1b, le relais de précharge S2 est ouvert et le relais de transfert S1 est fermé. Le relais de précharge S2 est destiné à court-circuiter la résistance de limitation RL une fois que la précharge de la capacité C1 est terminée. Lors d'une phase de fonctionnement du convertisseur 1b, le relais de transfert S1 reste fermé ainsi que le relais de précharge S2. Le relais de transfert S1 du circuit de commutation 2b est alors configuré pour autoriser ou couper le courant transféré entre la source de courant constant V1 et le convertisseur 1a.

Néanmoins, les relais à courant alternatif S1 et S2 pour les applications automobiles sont rares, et le circuit de commutation 2a ou 2b comprenant notamment la résistance de limitation RL est coûteux.

Pour pallier les inconvénients précités, la présente invention vise une solution moins couteuse qui permet de réaliser la précharge de la capacité sans utilisation du circuit de commutation typique comme décrit précédemment.

### PRESENTATION GENERALE DE L'INVENTION

Pour parvenir à ce résultat, la présente invention concerne un convertisseur configuré pour alimenter un élément consommateur d'énergie lors d'une phase de fonctionnement, ainsi que pour charger ladite capacité lors d'une phase de précharge préalable à la phase de fonctionnement. Ledit convertisseur comprend un circuit PFC (désigné « circuit de correction de facteur de puissance ») comportant ladite capacité et des thyristors. Ledit convertisseur comprend en outre un système de contrôle configuré pour contrôler ladite phase de précharge. Ledit système de contrôle comprend une unité de contrôle configurée pour, lors de ladite phase de précharge préalable, détecter l'état de charge de la capacité, ainsi que pour générer un signal de commande destiné à commander lesdits thyristors en fonction de l'état de charge de la capacité.

L'invention permet donc de réaliser la précharge de la capacité sans utilisation du circuit de commutation typique comme décrit précédemment.

La phase de fonctionnement est notamment une phase d'alimentation de l'élément consommateur d'énergie à travers ledit convertisseur.

Avantageusement, si l'unité de contrôle est configurée de sorte que le signal de commande comprend des impulsions de gâchette destinées auxdits thyristors de manière que les deux thyristors soient alternativement mis en état de conduction pour permettre la précharge de la capacité.

De façon avantageuse, les impulsions de gâchette sont notamment de durées variables. Ces durées d'impulsion de gâchette sont notamment déterminées au moins en fonction de l'état de charge de la capacité.

De façon avantageuse, le circuit PFC est configuré de sorte que, en phase de fonctionnement, lesdits thyristors fonctionnent comme des diodes.

De manière préférentielle, l'unité de contrôle est configurée pour, en phase de fonctionnement, générer un signal de commande comprenant un premier signal de gâchette et un deuxième signal de gâchette respectivement destinés à commander le premier thyristor et le deuxième thyristor, les deux signaux de gâchette étant chacun à un niveau haut. Notamment, les signaux de gâchette sont chacun à un niveau haut pendant toute la phase de fonctionnement.

Préférentiellement, l'unité de contrôle est configurée pour, en phase de fonctionnement, générer un signal de commande comprenant un premier signal de gâchette et un deuxième signal de gâchette respectivement destinés à commander le premier thyristor et le deuxième thyristor, et à chaque passage à zéro d'une tension d'alimentation, qu'un seul des signaux de gâchette comprenne une impulsion à un niveau haut, de sorte que lesdits thyristors sont alternativement commandés à la détection du passage à zéro.

Avantageusement, ledit système de contrôle comprend des circuits d'amorçage, respectivement dédiés à l'un desdits thyristors et respectivement configurés pour commander, en fonction dudit signal de commande, le thyristor auquel le circuit d'amorçage est dédié.

De façon avantageuse, lesdits circuits d'amorçage comprennent chacun un composant d'adaptation de signal configuré pour commander à travers une isolation galvanique.

De manière préférentielle, lesdits circuits d'amorçage comprennent chacun au moins une résistance et une diode, dans lequel la diode de l'un desdits circuits d'amorçage est connectée à un nœud correspondant à un point de connexion entre la capacité et le thyristor auquel le circuit d'amorçage est dédié ; la diode de l'autre desdits circuits d'amorçage étant connectée à un nœud correspondant à un point de connexion entre les thyristors connectés en série.

Préférentiellement, ledit circuit PFC comprend un premier bras comportant deux interrupteurs, un deuxième bras comportant deux interrupteurs ; ledit premier bras, ledit deuxième bras, un troisième bras comportant lesdits thyristors, la capacité, et l'élément consommateur d'énergie étant connectés entre deux nœuds.

Avantageusement, le circuit PFC est un circuit PFC en totem-pole entrelacé sans pont (désigné « interleaved totem pole bridgeless PFC » en anglais) ; la capacité étant une capacité de bus continue (désigné « DC-link Capacitor » en anglais).

De façon avantageuse, les interrupteurs du circuit PFC sont des transistors MOSFET (désigné « transistors à effet de champ à grille métal-oxyde ») ou des transistors IGBT (désigné « transistors bipolaires à grille isolée »).

### PRESENTATION DES FIGURES

D'autres caractéristiques et avantages de l'invention apparaîtront encore à la lecture de la description qui va suivre. Celle-ci est purement illustrative et doit être lue en regard des dessins annexés sur lesquels :
Fig. 1 : la figure 1 illustre une topologie de circuit PFC et un circuit de commutation conventionnels utilisés pour réaliser un convertisseur ;
Fig. 2 : la figure 2 illustre une autre configuration conventionnelle d'un circuit de commutation compris dans un convertisseur ;
Fig. 3 : la figure 3 illustre un convertisseur comprenant un système de contrôle selon un mode de réalisation de l'invention ;
Fig. 4 : la figure 4 est un diagramme d'intensités des courants et de tensions mesurées à différents moments quand le convertisseur est à la phase de précharge et à celle de transfert d'énergie, selon un mode de réalisation de l'invention ; et
Fig. 5 : la figure 5 illustre deux manières selon l'invention réalisées pour commander, en phase de fonctionnement, lesdits thyristors.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE D'UNE FORME DE REALISATION DE L'INVENTION

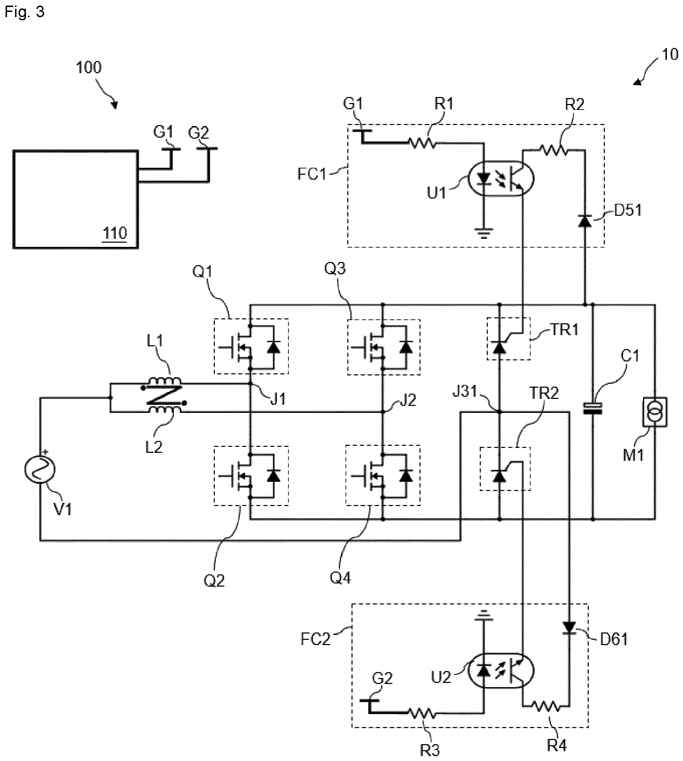

La figure 3 illustre un convertisseur 10 comprenant un système de contrôle 100 selon un mode de réalisation de l'invention. Le système de contrôle 100 comprend une unité de contrôle 110, un premier circuit d'amorçage FC1 et un deuxième circuit d'amorçage FC2. Le système de contrôle 100 est configuré pour contrôler un courant entre une source de tension alternative V1 et le convertisseur 10, soit lors d'une phase de précharge à laquelle une capacité C1 du convertisseur 10 est chargée, soit lors d'une phase de fonctionnement dans laquelle un élément consommateur d'énergie M1 consomme l'énergie électrique fournie par la source de tension alternative V1 à travers le convertisseur 10. Les composants électroniques ci-dessus du système de contrôle 100 seront décrits plus en détail dans les paragraphes suivants. De plus, il est noté que les éléments du convertisseur 10 référencés par les références mentionnées ci-dessus sont similaires à ceux du convertisseur 1a et 1b illustrés en figures 1 et 2.

Le convertisseur 10 comprend un circuit de correction du facteur de puissance (désigné « Power Factor Correction » en anglais, avec l'abréviation « PFC »). Le circuit PFC du convertisseur 10 comprend au moins un interrupteur, un transformateur et une capacité C1, qui sont de préférence des composants électroniques classiques d'un circuit PFC en totem-pole entrelacé sans pont (désigné « interleaved totem pole bridgeless PFC » en anglais) ou alternativement, d'un circuit PFC standard. La capacité C1 est de préférence une capacité de bus continue (désigné « DC-link Capacitor » en anglais). D'autres types de capacités similaires ou équivalentes à la capacité de type « DC-link » peuvent être utilisés.

Dans le mode de réalisation présent, le circuit PFC comprend quatre interrupteurs Q1 à Q4 qui sont préférentiellement des transistors à effet de champ à grille métal-oxyde (désigné « Metal Oxide Semiconductor Field Effect Transistor » en anglais, l'abréviation « MOSFET ») ou des transistors bipolaires à grille isolée (désigné « Insulated Gate Bipolar Transistor » en anglais, l'abréviation « IGBT »). De préférence, les interrupteurs Q1 et Q2 sont connectés en série et forment alors un premier bras. Les interrupteurs Q3 et Q4 sont connectés en série et forment un deuxième bras. Le premier et le deuxième bras sont connectés en parallèle.

Le transformateur comprend au moins deux inductances. Dans le présent mode de réalisation, le transformateur comprend une première inductance L1 et une deuxième inductance L2. La première inductance L1 est connectée à la source de tension alternative V1 et à un nœud J1 correspondant à un point milieu du premier bras, entre les interrupteurs Q1 et Q2. La deuxième inductance L2 est connectée à un nœud J2 correspondant à un point milieu du deuxième bras, entre les interrupteurs Q3 et Q4, et à la source de tension alternative V1. L'invention n'est néanmoins pas limitée au nombre d'interrupteurs ou au nombre d'inductances compris dans le circuit PFC du convertisseur 10.

Toutefois, au lieu de comprendre les diodes du circuit PFC conventionnel (e.g. les diodes D5 et D6 du convertisseur 1a ou 1b) qui ne peuvent pas contrôler le courant, le circuit PFC du convertisseur 10 comprend une pluralité de thyristors comprenant un premier thyristor TR1 et un deuxième thyristor TR2 qui sont connectés en série. Le premier thyristor TR1 et le deuxième thyristor TR2 sont respectivement connectés au premier circuit d'amorçage FC1 et au deuxième circuit d'amorçage FC2, de sorte à non seulement réaliser les redresseurs qui permettent de transformer le courant alternatif généré par la source de tension alternative V1 en courant unidirectionnel, mais aussi à contrôler, en coopération avec l'unité de contrôle 110, le courant de conduction unidirectionnelle. De plus, un nœud J31 correspondant à un point de connexion entre le premier thyristor TR1 et le premier thyristor TR2, est connecté à la fois à une borne négative de la source de tension alternative V1 et au deuxième circuit d'amorçage FC2.

Ledit premier bras, ledit deuxième bras, un troisième bras comportant lesdits thyristors TR1 et TR2, la capacité C1, et l'élément consommateur d'énergie M1 sont connectés entre deux nœuds.

Les thyristors TR1 et TR2 sont destinés à être commandés par un signal de commande généré en fonction d'un état de charge de la capacité C1. De manière préférentielle, le signal de commande comprend un premier signal de gâchette G1 et un deuxième signal de gâchette G2, respectivement destinés à commander le premier thyristor TR1 et le deuxième thyristor TR2.

Le premier circuit d'amorçage FC1 est connecté à l'unité de contrôle 110. Le premier circuit d'amorçage FC1, comprenant un premier composant d'adaptation de signal U1, au moins une résistance et une première diode D51, est configuré pour commander le premier thyristor TR1 en fonction d'un signal de commande issu de l'unité de contrôle 110.

Dans un mode de réalisation, le premier circuit d'amorçage FC1 comprend une première résistance R1 et une deuxième résistance R2. Le premier composant d'adaptation de signal U1 est connecté à la terre et à la première résistance R1 qui est connectée à l'unité de contrôle 110. Le premier composant d'adaptation de signal U1 est également connecté au premier thyristor TR1 du circuit PFC et à la deuxième résistance R2 qui est connectée à la première diode D51. La première diode D51 est connectée à un nœud correspondant à un point de connexion entre le premier thyristor TR1 et la capacité C1. Dans un mode de réalisation préférentiel, le premier circuit d'amorçage FC1 comprend une isolation galvanique. De manière avantageuse, le premier composant d'adaptation de signal U1 permet de transmettre un signal à travers de cette isolation galvanique. Le premier composant d'adaptation de signal U1 est par exemple un optocoupleur, ou un isolateur numérique sans ou avec transistor de type push-pull.

L'unité de contrôle 110 est également connectée au deuxième circuit d'amorçage FC2. En termes de topologie de circuit, le deuxième circuit d'amorçage FC2 est similaire au premier circuit d'amorçage FC1.

Le deuxième circuit d'amorçage FC2 comprend un deuxième composant d'adaptation de signal U2, au moins une résistance, et une deuxième diode D61, et il est configuré pour commander le deuxième thyristor TR2 du circuit PFC en fonction du signal de commande issu de l'unité de contrôle 110.

Dans un mode de réalisation, le deuxième circuit d'amorçage FC2 comprend une troisième résistance R3 et une quatrième résistance R4. Le deuxième composant d'adaptation de signal U2 est connecté à la terre et à la troisième résistance R3 qui est connectée à l'unité de contrôle 110 par G3. Le deuxième composant d'adaptation de signal U2 est également connecté au deuxième thyristor TR2 et à la quatrième résistance R4 qui est connectée à la deuxième diode D61. La deuxième diode D61 est connectée audit nœud J31 entre lesdits thyristors TR1 et TR2. Dans un mode de réalisation préférentiel, le deuxième circuit d'amorçage FC2 comprend une isolation galvanique. De manière avantageuse, le deuxième composant d'adaptation de signal U2 permet de transmettre un signal à travers de cette isolation galvanique. Le deuxième composant d'adaptation de signal U2 est par exemple un optocoupleur, ou un isolateur numérique sans ou avec transistor de type push-pull.

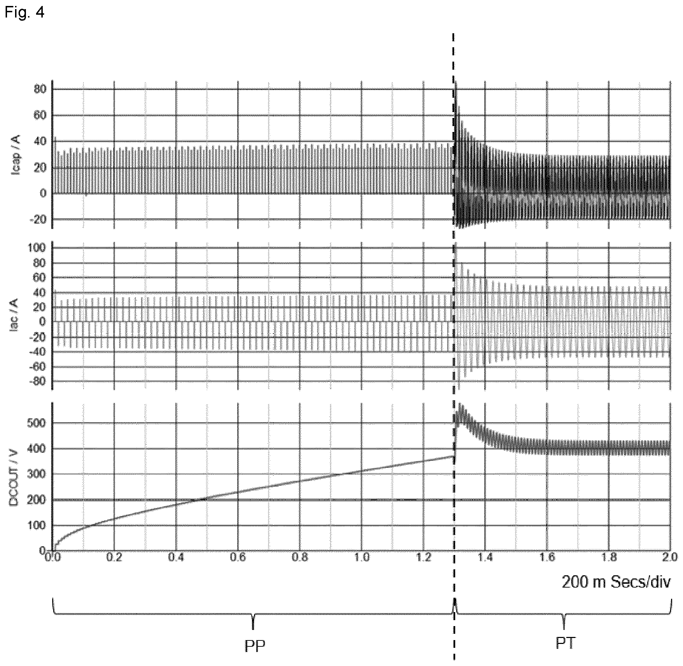

Le convertisseur 10 peut être soit à la phase de précharge soit à la phase de fonctionnement, comme décrit en figure 4. La figure 4 est un diagramme d'intensités des courants « Icap », « lac » et de tensions « DCOUT » mesurées à différents moments quand le convertisseur 10 est à la phase de précharge (i.e. référencée par « PP » en figure 4) et à celle de transfert d'énergie (i.e. référencée par « PT »), selon un mode de réalisation de l'invention. Les termes « Icap », « lac » et « DCOUT » signifient respectivement le courant passant dans la capacité C1, le courant d'entrée généré par la source de tension alternative V1, et la tension aux bornes de la capacité C1.

Comme mentionné précédemment, avant de passer à la phase de fonctionnement, la capacité C1 doit impérativement et préalablement être suffisamment chargée de sorte à éviter un courant d'appel lors de la phase de fonctionnement du convertisseur 10.

L'unité de contrôle 110 est alors configurée pour détecter l'état de charge de la capacité C1, au moins en fonction de la tension aux bornes de la capacité C1. L'unité de contrôle 110 est ensuite configurée pour générer le signal de commande en fonction de l'état de charge de la capacité C1.

De manière avantageuse, l'état de charge de la capacité C1 est déterminé par une comparaison entre la tension aux bornes de la capacité C1 et un seuil d'énergie prédéfini. Si la tension aux bornes de la capacité C1 est inférieure audit seuil d'énergie prédéfini, la capacité C1 est considérée comme insuffisamment chargée. Ainsi, l'état de charge de la capacité C1 implique que le convertisseur 10 doit entrer dans la phase de précharge, comme décrit dans l'exemple de la figure 4. Selon cet exemple de la figure 4, au bout de 1.3 seconde après le début de la phase de fonctionnement PT, le convertisseur 10 entre dans une phase de précharge PP.

Lors de la phase de précharge, l'unité de contrôle 110 détermine, en fonction de la tension aux bornes de la capacité C1, une durée de précharge souhaitée au bout de laquelle la capacité C1 est considérée comme suffisamment chargée. A cette fin, l'unité de contrôle 110 est configurée pour générer, comme mentionné ci-dessus, le signal de commande comprenant des impulsions de gâchette destinées auxdits thyristors TR1 et TR2 et appliquées pendant des durées d'impulsion variables déterminées au moins en fonction de la tension aux bornes de la capacité C1 et/ou de la durée de précharge souhaitée.

Le premier et le deuxième circuits d'amorçage FC1 et FC2 commandent donc respectivement, en fonction du signal de commande généré par l'unité de contrôle 110, le premier thyristor TR1 et le deuxième thyristor TR2. A la phase de précharge, les impulsions de gâchette sont appliquées aux deux thyristors TR1 et TR2 en fonction dudit signal de commande, de manière à ce que lesdits deux thyristors TR1 et TR2 soient alternativement mis en état de conduction pour permettre la précharge de la capacité C1 avant une alimentation de l'élément consommateur d'énergie M1. De cette manière, un contrôle de l'angle d'amorçage du premier thyristor TR1 et celui de l'angle d'amorçage du deuxième thyristor TR2 peuvent être réalisés.

Les impulsions de gâchette appliquées auxdits thyristors TR1 et TR2 peuvent être retardées d'un certain temps en fonction du signal de commande. La conduction est ainsi contrôlée de manière à réaliser la charge de la capacité C1 pendant ladite durée de précharge souhaitée.

Si l'énergie électrique stockée dans la capacité C1 est égale ou supérieure au seuil d'énergie prédéfini, la capacité C1 est considérée comme suffisamment chargée. L'état de charge de la capacité C1 implique donc que le convertisseur 10 peut être dans la phase de fonctionnement et donc être apte à alimenter l'élément consommateur d'énergie M1.

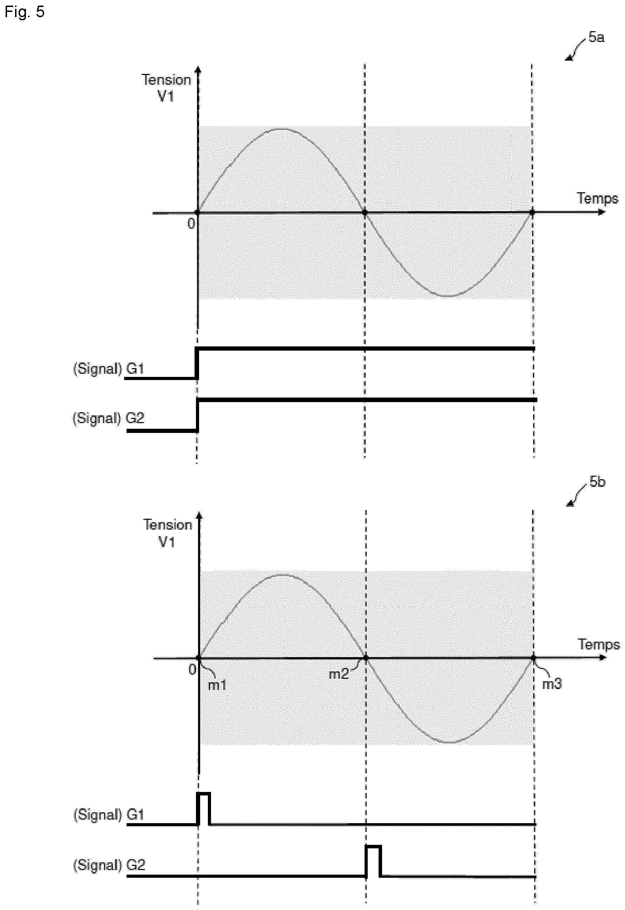

Lors de la phase de fonctionnement, lesdits thyristors TR1 et TR2 fonctionnent comme des diodes. La figure 5 illustre deux manières (référencées respectivement par « 5a » et « 5b ») réalisées pour commander, en phase de fonctionnement, lesdits thyristors TR1 et TR2. Dans un mode de réalisation illustré par l'exemple 5a en figure 5, les signaux de la gâchette G1 et G2 du signal de commande sont chacun à un niveau haut continuellement pendant la phase de fonctionnement. Ainsi, les lesdits thyristors TR1 et TR2 sont toujours commandés.

Dans un autre mode de réalisation illustré par l'exemple 5b en figure 5, à chaque passage à zéro de la tension d'alimentation fournie par la source de tension alternative V1 (e.g. aux moments m1, m2 et m3 de l'exemple 5b), un seul des signaux de gâchette G1 et G2 est actif. Les signaux de gâchette G1 et G2 comprennent chacun une impulsion de gâchette à un niveau haut et sont tels que lesdits thyristors TR1 et TR2 sont alternativement commandés à la détection du passage à zéro, correspondant à un front montant ou à un front descendant, selon qu'il s'agisse du premier thyristor TR1 ou du deuxième thyristor TR2. Autrement dit, un seul thyristor reçoit une commande en fonction de l'alternance de la tension alternative d'alimentation fournie par la source de tension alternative V1. Pour un passage d'une tension négative à une tension positive, c'est le premier thyristor TR1 qui est amorcé. Pour un passage d'une tension positive à une tension négative, c'est le deuxième thyristor TR2 qui est amorcé. Ainsi, chaque thyristor TR1, TR2 est amorcé au passage à zéro de la tension d'alimentation fournie par la source de tension alternative V1 par le signal de gâchette qui lui est dédié (i.e. G1 pout TR1 et G2 pour TR2). Chaque thyristor TR1, TR2 s'éteint automatiquement lorsque la différence de tension entre son anode et sa cathode devient négative. C'est-à-dire lorsque la tension d'alimentation fournie par la source de tension alternative V1 passe de l'alternance positive à l'alternance négative pour le premier thyristor TR1 ; et de même lorsque la tension d'alimentation fournie par la source de tension alternative V1 passe de l'alternance négative à l'alternance positive pour le deuxième thyristor TR2.

L'invention utilise l'unité de contrôle 110, au lieu d'utiliser un circuit de commutation typique (i.e. circuits de commutation 2a et 2b décrit en figures 1 ou 2), pour déterminer à un instant donné où le convertisseur 10 doit être à la phase de précharge ou non, ce qui permet de réaliser la précharge de la capacité C1 de manière automatique sans nécessiter d'utilisation du circuit de commutation typique. Ainsi, par rapport aux circuits de contrôle typique, le système de contrôle 100 est plus efficace et présente des avantages suivants : de réduire la taille et le coût de fabrication du convertisseur 10, de simplifier la fabrication du convertisseur 10 et d'améliorer la fiabilité du convertisseur 10.

L'invention n'est pas limitée aux modes de réalisation précédemment décrits mais s'étend à tout mode de réalisation conforme à son esprit.

## Revendications

1. Convertisseur (10), configuré pour alimenter un élément consommateur d'énergie (M1) lors d'une phase de fonctionnement, ledit convertisseur (10) comprenant un circuit PFC (désigné « circuit de correction de facteur de puissance») comportant une capacité (C1), ledit convertisseur (10) étant configuré pour charger ladite capacité (C1) lors d'une phase de précharge préalable à la phase de fonctionnement, ledit convertisseur (10) comprenant un système de contrôle (100) configuré pour contrôler ladite phase de précharge ; le convertisseur (10) étant **caractérisé en ce que** :
- ledit circuit PFC comprend des thyristors (TR1, TR2) ; et
- ledit système de contrôle (100) comprend une unité de contrôle (110) configurée pour, lors de ladite phase de précharge, détecter l'état de charge de la capacité (C1), ainsi que pour générer un signal de commande destiné à commander lesdits thyristors (TR1, TR2) en fonction de l'état de charge de la capacité (C1).

2. Convertisseur (10) selon la revendication 1, dans lequel l'unité de contrôle (110) est configurée de sorte que le signal de commande comprend des impulsions de gâchette destinées auxdits thyristors (TR1, TR2) de manière que les deux thyristors (TR1, TR2) sont alternativement mis en état de conduction pour permettre la précharge de la capacité (C1).

3. Convertisseur (10) selon la revendication 1 ou 2, dans lequel le circuit PFC est configuré de sorte que, en phase de fonctionnement, lesdits thyristors (TR1, TR2) fonctionnent comme des diodes.

4. Convertisseur (10) selon la revendication 3, dans lequel l'unité de contrôle (110) est configurée pour, en phase de fonctionnement, générer un signal de commande comprenant un premier signal de gâchette (G1) et un deuxième signal de gâchette (G2) respectivement destinés à commander le premier thyristor (TR1) et le deuxième thyristor (TR2), les deux signaux de gâchette (G1, G2) étant chacun à un niveau haut.

5. Convertisseur (10) selon la revendication 3, dans lequel l'unité de contrôle (110) est configurée pour, en phase de fonctionnement,
générer un signal de commande comprenant un premier signal de gâchette (G1) et un deuxième signal de gâchette (G2) respectivement destinés à commander le premier thyristor (TR1) et le deuxième thyristor (TR2), et
à chaque passage à zéro d'une tension d'alimentation (V1), qu'un seul des signaux de gâchette (G1, G2) comprenne une impulsion à un niveau haut, de sorte que lesdits thyristors (TR1, TR2) sont alternativement commandés à la détection du passage à zéro.

6. Convertisseur (10) selon une quelconque des revendications 1 à 5, dans lequel ledit système de contrôle (100) comprend des circuits d'amorçage (FC1, FC2), respectivement dédiés à l'un desdits thyristors (TR1, TR2) et respectivement configurés pour commander, en fonction dudit signal de commande, le thyristor auquel le circuit d'amorçage est dédié.

7. Convertisseur (10) selon la revendication 6, dans lequel lesdits circuits d'amorçage (FC1, FC2) comprennent chacun un composant d'adaptation de signal (U1, U2) configuré pour commander à travers une isolation galvanique.

8. Convertisseur (10) selon la revendication 7, dans lequel lesdits circuits d'amorçage (FC1, FC2) comprennent chacun au moins une résistance (R1 à R4) et une diode (D51, D61), et dans lequel la diode (D51) de l'un desdits circuits d'amorçage (FC1) est connectée à un nœud correspondant à un point de connexion entre la capacité (C1) et le thyristor (TR1) auquel le circuit d'amorçage (FC1) est dédié ; la diode (D61) de l'autre desdits circuits d'amorçage (FC2) étant connectée à un nœud (J31) correspondant à un point de connexion entre les thyristors (TR1, TR2) connectés en série.

9. Convertisseur (10) selon une quelconque des revendications 1 à 8, dans lequel ledit circuit PFC comprend un premier bras comportant deux interrupteurs (Q1, Q2), un deuxième bras comportant deux interrupteurs (Q3, Q4) ; ledit premier bras, ledit deuxième bras, un troisième bras comportant lesdits thyristors (TR1, TR2), la capacité (C1), et l'élément consommateur d'énergie (M1) étant connectés entre deux nœuds.

10. Convertisseur (10) selon une quelconque des revendications 1 à 9, dans lequel le circuit PFC est un circuit PFC en totem-pole entrelacé sans pont (désigné « interleaved totem pole bridgeless PFC » en anglais) ; la capacité (C1) étant une capacité de bus continue (désigné « DC-link Capacitor » en anglais).
